# FASCICULE DE BREVET EUROPEEN

(11) **EP 2 697 825 B1**
(45) Date de publication et mention de la délivrance du brevet: **19.07.2017**
(21) Numéro de dépôt: 12712702.5
(22) Date de dépôt: 11.04.2012
(51) Int. Cl.: H01L 21/77

(54) **PROCÉDÉ DE FABRICATION D'UN DISPOSITIF OPTO-MICROÉLECTRONIQUE**
VERFAHREN ZUR HERSTELLUNG EINER OPTOELEKTRISCHEN VORRICHTUNG
METHOD FOR MANUFACTURING AN OPTO-MICROELECTRONIC DEVICE

(30) Priorité: 14.04.2011 FR 1153259
(43) Date de publication de la demande: 19.02.2014
(73) Titulaire: Commissariat à l'Énergie Atomique et aux Énergies Alternatives, 75015 Paris (FR)
(72) Inventeur: ROSSINI, Umberto, F-38500 Coublevie (FR)
(74) Mandataire: Decobert, Jean-Pascal
(86) Numéro de dépôt international: PCT/EP2012/056595
(87) Numéro de publication internationale: WO 2012/140094

(56) Documents cités:
- US-A1- 2010 078 644
- US-A1- 2010 289 064

## Description

### DOMAINE TECHNIQUE DE L'INVENTION

La présente invention concerne en général la réalisation de dispositifs notamment ceux à base de semi conducteurs nécessitant le transfert de couches fonctionnelles réalisées à la surface d'un substrat sur un autre support tels que des dispositifs hybrides, notamment ceux qui combinent électronique et optique. L'invention répond plus particulièrement au problème des déformations géométriques qui sont induites par le transfert.

La fabrication de tout dispositif microélectronique est visée par l'invention. Par dispositif microélectronique, on entend tout type de dispositif réalisé avec des moyens de la microélectronique. Les dispositifs englobent notamment en plus des dispositifs à finalité purement électronique, des dispositifs micromécaniques ou électromécaniques, tels les MEMS (microelectromechanical systems) ou les NEMS (nanoelectromechanical systems) ainsi que les dispositifs optiques ou opto électroniques (tels les MOEMS micro optical electromechanical systems).

Une application particulière de l'invention est la réalisation d'imageurs de petites dimensions et notamment de moins de 1 pouce, soit 2,54 centimètres. Sont entres autres concernés les imageurs à technique transmissive dans lesquels des rayons lumineux sont générés d'une source située du côté opposé à la face de sortie (ou écran) des images.

### ÉTAT DE LA TECHNIQUE

L'industrie de la micro électronique a recours à des techniques de plus en plus sophistiquées pour pouvoir réaliser toutes sortes de dispositifs qui requièrent, au moins en partie, la mise en oeuvre de fonctions électroniques performantes. Ces techniques demandent notamment de pouvoir transférer une couche fonctionnelle réalisée à la surface d'un premier substrat, typiquement un substrat semi conducteur, sur un second substrat, dans le but, par exemple d'augmenter la densité d'intégration en permettant que cette intégration puisse se faire non seulement en surface mais aussi en volume, en empilant des couches fonctionnelles produites séparément. Le transfert de couches fonctionnelles est souvent aussi destiné à permettre de conférer aux dispositifs produits des caractéristiques fonctionnelles qu'ils ne pourraient acquérir autrement comme par exemple une meilleure isolation électrique pour des applications où de fortes tensions sont appliquées ou d'obtenir qu'ils soient transparents comme c'est souvent nécessaire pour des dispositifs optoélectroniques de type imageurs. Il s'agit alors typiquement d'afficheurs de petite taille, moins de un pouce (25,4 mm), et aussi de projecteurs qualifiés de micro, voire nano, projecteurs qui sont produits avec les techniques de l'industrie de la microélectronique afin de pouvoir combiner des moyens électroniques performants, à base de transistors faits d'un matériau semi conducteur monocristallin, avec des composants optiques comme par exemple les cristaux liquides en vue de leur utilisation dans toutes sortes de dispositifs portables comme les téléphones, ordinateurs et autres appareillages mobiles.

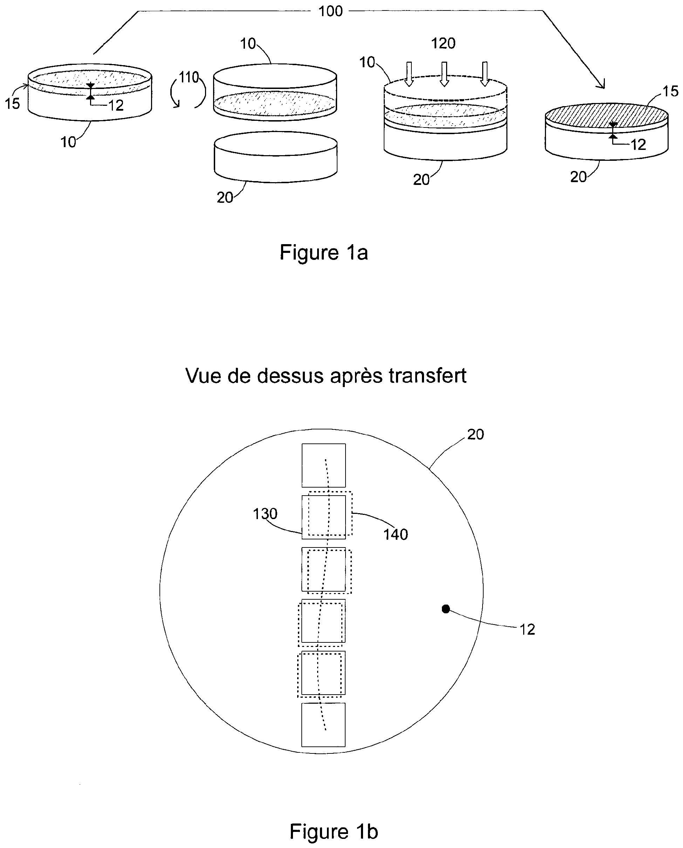

Quel que soit le type de dispositif considéré, si sa réalisation demande d'avoir recours au transfert d'une couche fonctionnelle depuis un premier substrat vers un second substrat, ce transfert entraîne toujours une déformation géométrique de la mince couche transférée, qualifiée de déformation de nappe. Ce problème est illustré sur les **figures 1a** et **1b****.** La figure 1a montre un premier substrat 10, généralement un substrat semi conducteur, à la surface duquel une couche fonctionnelle 12 aura été réalisée en utilisant possiblement toutes les techniques mises au point par l'industrie de la microélectronique depuis des décennies. Notamment, toutes les techniques destinées à produire les circuits intégrés sont susceptibles d'être utilisées de façon à réaliser dans cette couche tout ou partie de la fonction électronique du dispositif. Le premier substrat 10 pourra notamment être un substrat élaboré de type SOI, de l'anglais « silicon on insulator », c'est-à-dire un substrat « silicium sur isolant » dans lequel on aura réalisé, dans sa mince couche superficielle de silicium monocristallin, au dessus d'une «couche d'oxyde enterrée » 15 le plus souvent désignée par son acronyme BOX de l'anglais « buried oxyde layer », des composants nécessaires et qui deviendra la couche fonctionnelle 12.

Le transfert 100 de la couche 12 sur le second substrat 20 se pratique alors de façon conventionnelle en collant, après retournement 110, le premier substrat sur la face supérieure du second substrat 20. Différentes techniques de collage pour rendre solidaire les deux substrats sont connues qui permettent de faire adhérer des surfaces faites des matériaux semi conducteurs couramment utilisés et notamment le silicium et son oxyde (Si02). Il peut s'agir notamment d'un collage direct (c'est-à-dire sans apport d'une substance adhésive) ou d'un collage au moyen d'un adhésif. La couche fonctionnelle 12 reste en place sur le second substrat après enlèvement ou séparation 120 du premier substrat. Différentes techniques sont là aussi connues et pratiquées pour ne laisser en place sur le second substrat que la couche fonctionnelle 12. Notamment, dans le cas d'utilisation d'un premier substrat de type SOI celui-ci, après collage, peut est attaqué mécaniquement et chimiquement 120 jusqu'à sa couche d'oxyde enterrée 15. Il ne reste finalement en place sur le second substrat 20 que la mince couche de silicium monocristallin du substrat SOI de départ, couche à partir de laquelle les composants de la couche fonctionnelle 12 auront été réalisés, éventuellement protégée par sa couche d'oxyde enterrée 15 (tout ou partie de cette couche pouvant être également retirée).

Cependant, quelle que soit la technique employée pour le transfert, une déformation de nappe se produit. Le résultat en est schématisé sur la figure 1 b. Les motifs 140 définissant les composants réalisés sur la surface totale d'une tranche n'occupent plus alors exactement leur position nominale initiale 130 qui avait été définie précisément, lors des étapes de fabrication de la couche fonctionnelle 12 sur le premier substrat, le plus souvent par photolithographie. Ceci impacte sérieusement le placement de la partie des dispositifs qui reste à fabriquer après transfert.

Par exemple, pour des imageurs de petites tailles, le placement incertain des composants, tels les électrodes de pixel, pénalise la qualité optique de l'appareil fabriqué. En particulier, le taux d'ouverture des pixels (OAR, pour Open Aperture Ratio) est fortement réduit.

Le document US A1 2010/078644 montre une méthode pour fabriquer un dispositif selon le préambule de la revendication 1. Il montre un substrat de type TFT (pour Thin Film Transistor) avec des électrodes de pixel sans répondre pour autant au problème du placement de ces électrodes.

Il existe donc un besoin pour au moins limiter les inconvénients dus aux déformations de nappe lors de transferts.

On connait par ailleurs, de la publication US A1 2010/289064, un dispositif semi-conducteur comprenant une pluralité de couches empilées et des transistors organisés dans une couche fine de transistors. Cette divulgation se concentre sur la réalisation des transistors. Une configuration spécifique des grilles des transistors y est présentée.

### RÉSUMÉ DE L'INVENTION

Suivant un aspect, l'invention concerne un procédé de fabrication d'un dispositif microélectronique selon la revendication 1.

Ce procédé assure un auto alignement des électrodes de pixel et aucune méthode, telle une photolithographie, n'est nécessaire après transfert pour leur réalisation, si bien que la précision du placement est accrue.

Alors que les efforts de l'homme du métier ont jusqu'ici porté sur les moyens propres à réduire la déformation de nappe elle-même, l'invention décrit un procédé de fabrication qui permet d'accommoder cette déformation sans porter atteinte à la précision de réalisation des dispositifs, ni avant ni après transfert. Le procédé de l'invention s'applique notamment, mais n'est pas limité, au cas des dispositifs optoélectroniques tels des imageurs mentionnés précédemment qui doivent être réalisés sur un substrat transparent.

Les autres objets, caractéristiques et avantages de la présente invention apparaîtront à l'examen de la description suivante et des dessins d'accompagnement. Il est entendu que d'autres avantages peuvent être incorporés.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURE 1a et 1b illustrent le problème adressé par l'invention qui concerne la déformation de nappe résultant du transfert d'une couche fonctionnelle, réalisée sur un premier substrat, sur un second substrat.
Les FIGURES 2a à 2h illustrent une première mise en oeuvre du procédé selon l'invention qui permet de s'affranchir de la déformation de nappe en prenant comme exemple la réalisation d'un dispositif optoélectronique de type imageur.
Les FIGURE 3a à 3c illustrent une seconde mise en oeuvre du procédé selon l'invention dans laquelle on effectue d'abord un transfert de la couche fonctionnelle sur un substrat auxiliaire.
La FIGURE 4 montre l'intérêt qu'il y a à pouvoir éclairer le dispositif optoélectronique utilisé pour décrire l'invention depuis la contre électrode du côté de la couche de cristaux liquides.
La FIGURE 5 décrit une étape optionnelle de la seconde mise en oeuvre du procédé selon l'invention permettant de créer un écran protégeant optiquement les transistors de sélection de la lumière pouvant provenir du second substrat.
La FIGURE 6a est une vue de dessus partielle de la figure 2a. La FIGURE 6b montre en vue de dessus partielle la configuration de la figure 2c. La FIGURE 6c schématise une étape de transfert d'une partie d'un substrat.

Les dessins joints sont donnés à titre d'exemples et ne sont pas limitatifs de l'invention.

### DESCRIPTION DÉTAILLÉE DE L'INVENTION

Dans la présente demande, la réalisation d'au moins un composant électronique s'entend d'une étape ou une suite d'étape aboutissant à la formation concrète d'un composant électronique. Le composant électronique est ainsi, selon l'invention, réellement formé à cette étape de réalisation. Cela n'exclut pas que des phases préparatoires soient faites avant la réalisation du composant électronique. Ce composant peut être tout élément apte à réaliser une fonction dans un dispositif microélectronique dont ceux visés dans la section « domaine technique de l'invention ». Le composant électronique est un conducteur électrique formant une électrode.

Il s'agit d'une électrode de pixel, en particulier pour un imageur de moins de 2,54 centimètres de diagonale d'écran.

Il peut aussi former ou participer à former un organe utile optiquement tel un écran de barrière à des rayons lumineux issus d'une source.

Dans le mode de réalisation discuté ci-après, le composant électronique est une électrode d'un pixel.

Généralement, selon l'invention, une pluralité de composants identiques ou similaires sera fabriquée simultanément mais ce cas n'est pas limitatif.

Avant d'entamer la description en référence aux dessins, des caractéristiques avantageuses optionnelles de l'invention sont ci après introduites. Elles peuvent être utilisées alternativement ou cumulativement :
- la première phase comprend la délimitation latérale du motif dans la couche du premier substrat par une bordure en un matériau de délimitation différant du matériau sacrificiel.
- le motif est un caisson entouré latéralement intégralement par la bordure.
- la bordure est obtenue, par dépôt autour du motif, du matériau de délimitation et en formant une couche de matériau de délimitation au dessus de la couche comprenant le motif.
- il comprend après dépôt autour du motif, l'amincissement de la couche de matériau de délimitation jusqu'à obtenir une épaisseur inférieure à la dimension latérale minimale et à l'épaisseur de la bordure.
- la première phase comprend la formation d'un écran à la lumière en superposition au motif.
- l'écran est formé par photolithographie dans une couche du premier substrat superposée à la couche incluant le motif.
- le remplacement du motif par le composant électronique comprend l'enlèvement du matériau sacrificiel du motif.
- l'enlèvement du matériau sacrificiel du motif est effectué par gravure sélective de sorte à attaquer le matériau sacrificiel et à préserver le matériau de délimitation.
- la deuxième phase comprend, après l'enlèvement du matériau sacrificiel du motif, l'enlèvement de la couche de matériau de délimitation.
- l'enlèvement de la couche de matériau de délimitation est effectué par gravure de temps contrôlé de sorte enlever la couche de matériau de délimitation et à préserver la bordure.
- le remplacement du motif par le composant électronique comprend, après l'enlèvement du matériau sacrificiel du motif, un dépôt du matériau du composant électronique.
- il comprend un amincissement de l'épaisseur du dépôt du matériau du composant électronique jusqu'au niveau de l'épaisseur de la bordure.
- il comprend, avant le transfert, la formation de la couche incluant le motif sur une couche sous jacente du premier substrat, suivie de la formation d'au moins une couche incluant au moins un composant électronique additionnel puis de la formation d'une couche d'assemblage.
- le transfert du premier substrat sur le deuxième substrat est effectué par la couche d'assemblage du premier substrat et on réduit l'épaisseur du premier substrat par la couche sous jacente jusqu'à la couche incluant le motif.
- il comprend, avant le transfert, la formation d'au moins une couche incluant au moins un composant électronique additionnel sur une couche sous jacente du premier substrat, suivie de la formation de la couche incluant le motif puis de la formation d'une couche d'assemblage.
- le transfert comprend :
   - Un transfert du premier substrat par une face externe de la couche d'assemblage sur un substrat intermédiaire,
   - Une réduction de l'épaisseur du premier substrat par la couche sous jacente jusqu'au niveau d'une face interne,
   - Un transfert du premier substrat par la face interne sur le deuxième substrat,
   - Une élimination du substrat intermédiaire et une réduction de l'épaisseur du premier substrat par la couche d'assemblage jusqu'à la couche incluant le motif.
- la formation d'au moins un motif comporte une phase de photolithographie.
- le matériau sacrificiel est de l'oxyde de silicium.
- on choisit du nitrure de silicium comme matériau de délimitation.
- la bordure est en un matériau de délimitation différent du matériau de délimitation de la couche.
- la fabrication d'un imageur de diagonale de moins de 2,54 centimètres à éclairage transmissif.

Dans les exemples qui suivent, il est fait référence à des choix de matériaux dont la sélection est avantageuse pour l'invention. Néanmoins ces sélections ne sont pas limitatives des modes de réalisation de l'invention.

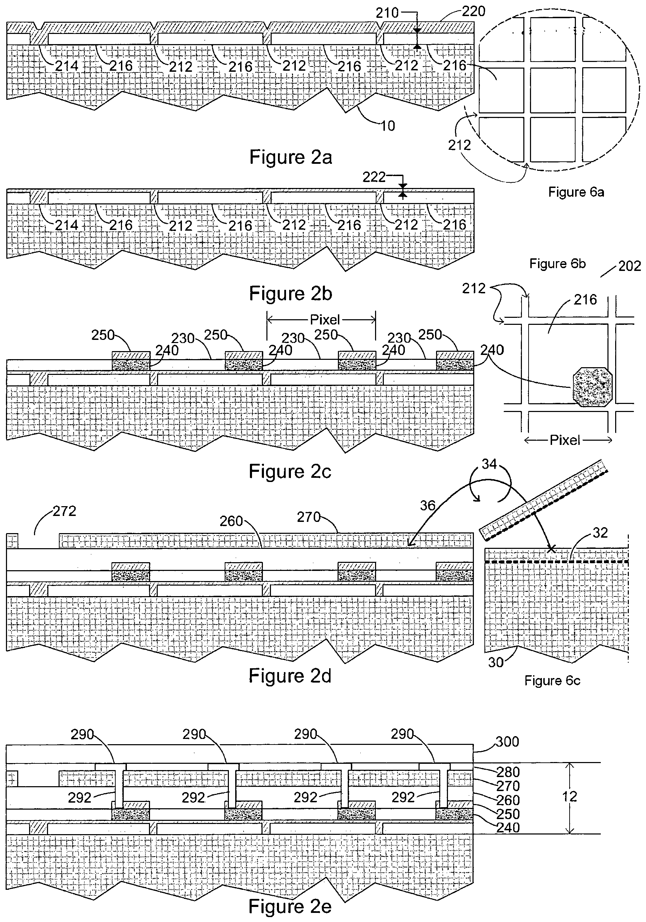

Les **figures 2a à 2h** illustrent une première mise en oeuvre du procédé selon l'invention qui permet de s'affranchir de la déformation de nappe après transfert.

Bien que l'invention soit décrite ci-après sur la base de la réalisation d'un dispositif optoélectronique de type imageur sur un substrat transparent l'invention n'est en rien limitée à cet exemple particulier. L'homme du métier saura facilement adapter le procédé à d'autres substrats et d'autres applications et pour des dispositifs qui ne sont pas nécessairement de type optoélectronique.

Dans l'exemple choisi pour décrire l'invention il s'agit, comme déjà brièvement mentionné dans le chapitre sur l'état de la technique, de réaliser la matrice de pixels d'un imageur de type micro projecteur. Ce type de projecteur, de petite taille souvent, bien inférieure au pouce (25,4 mm), est conçu pour pouvoir projeter directement des images à partir du dispositif portable dans lequel il est intégré. Les pixels sont alors nécessairement eux-mêmes de petite taille, typiquement quelques microns (un micron ou micromètre = 10⁻⁶ mètre) de côté. La matrice peut comprendre quelques centaines de milliers voire plusieurs millions de ces pixels en fonction des applications. Chaque pixel est associé à au moins un transistor de sélection qui doit avantageusement occuper une surface la plus petite possible afin de laisser transparente la surface restante de chaque pixel et ainsi obtenir un taux d'ouverture le plus élevé possible. Le taux d'ouverture ou OAR, de l'anglais « open aperture ratio », est le rapport entre surface transparente et surface opaque de chaque pixel. La partie optique est généralement faite d'une couche de cristaux liquides le plus souvent désignés par leur acronyme LC's de l'anglais « liquid crystals ». Alors que les afficheurs et imageurs traditionnels de grandes tailles (dizaines de pouces) à cristaux liquides se contentent d'utiliser des transistors en couches minces dits TFT, de l'anglais « thin film transistor », obtenus à partir d'un dépôt à basse température de silicium polycristallin ou amorphe, et qui sont peu performants, les transistors de sélection et toute l'électronique périphérique sont avantageusement ici réalisés à partir d'une couche de silicium monocristallin qui permet d'obtenir des transistors de très petite taille cependant très performants. Il faut donc pouvoir les fabriquer sur un premier substrat semi conducteur avant de les transférer sur un second substrat transparent. Ce transfert est la source de la déformation de nappe avec les inconvénients décrits précédemment.

Le procédé décrit ci-après apporte une solution au positionnement des pixels, après transfert, par rapport aux transistors de sélection, en définissant la géométrie des pixels dès les toutes premières étapes du procédé, avant même la formation des transistors de sélection dans la couche transférée.

Comme montré sur la **figure 2a** le procédé de fabrication de l'invention consiste à partir d'un premier substrat 10 avantageusement semi conducteur standard pour former une première partie du dispositif. Typiquement, il s'agit d'une tranche pleinement constituée de silicium monocristallin et d'une épaisseur suffisante pour pouvoir être manipulée sans difficulté. Les tranches les plus grandes ont actuellement par exemple un diamètre jusqu'à 30 cm et sont d'une épaisseur de plusieurs centaines de microns afin de leur conférer une rigidité mécanique suffisante.

On fait alors croître thermiquement sur le substrat une couche 210 d'oxyde de silicium (SiO2) dans laquelle on va définir par photolithographie les motifs des pixels qui seront effectivement réalisés après transfert. Selon l'invention, de tels motifs sont avantageusement formés pour déterminer l'emplacement du composant électronique (telle une électrode) à réaliser ultérieurement. Ces motifs peuvent être des caissons 216, par exemple de section rectangulaire ou carré, formés dans l'épaisseur d'une couche du premier substrat 10. Il n'est pas exclu que ladite couche soit composée d'une pluralité de sous couches. La couche 210 de SiO2 représentée a typiquement une épaisseur de 250 nm. Comme montré sur la vue de dessus (fig. 6a) par exemple, les motifs sont typiquement des carrés de quelques microns de côté délimités par des ouvertures 212 dans l'oxyde. Les ouvertures 212 ont typiquement une largeur de 0,5 micron. On note aussi la présence d'une ouverture 214 qui laisse apparente les marques de positionnement (non représentées) gravées dans le silicium et qui sont utiles pour le positionnement des opérations de lithographie qui suivent. La figure 2a montre une coupe du dispositif en cours d'élaboration après qu'une couche 220 d'un matériau de délimitation des motifs d'électrodes de pixels a aussi été déposée sur toute la surface. Le matériau est par exemple du nitrure de silicium ou du silicium polycristallin.

Suivant une possibilité de réalisation, la délimitation latérale (c'est-à-dire suivant le plan du substrat) peut être faite avec un premier matériau (tel du nitrure de silicium ou du silicium polycristallin) et la délimitation en fond de caisson peut être faite en un deuxième matériau (tel que, respectivement, du silicium polycristallin ou du nitrure de silicium). On peut ainsi jouer sur la différence de matériau lors de l'attaque chimique sélective qui va suivre.

Ce matériau est déposé en épaisseur suffisante pour remplir toutes les ouvertures 212, lesquelles vont alors constituer une bordure de délimitation des pixels géométriquement définis à ce stade préliminaire par les motifs formant chacun un caisson 216 rempli d'oxyde de silicium correspondant à la couche 210. Cette couche d'oxyde est une couche sacrificielle. En fin de procédé, comme on va le voir ci-après, les caissons 216 d'oxyde seront gravés par gravure chimique (par exemple à l'aide d'une « gravure ionique réactive » dite RIE de l'anglais « Reactive Ion Etching »*)* qui sera confinée par la couche de nitrure 220 qui les entoure avantageusement complètement.

La **figure 2b** montre une coupe du dispositif en cours d'élaboration après que la couche 220 de nitrure de silicium a été aplanie par un traitement de polissage mécano chimique désigné par l'acronyme CMP de l'anglais « chemical mechanical polishing ». On ne laisse subsister de la couche 220 qu'une mince épaisseur 222, typiquement 50 nanomètres (1 nanomètre ou nm = 10⁻⁹ mètre), au dessus des caissons 216. L'épaisseur est préférentiellement inférieure à la largeur des bordures latérales. Optionnellement, il est possible de ne laisser subsister de la couche 220 que les zones situées entre les caissons 216 et de déposer sur l'ensemble une couche continue 222 d'un autre matériau qui servira à délimiter, ce qui deviendra par la suite, le « fond » des caissons.

La **figure 2c** montre le résultat de plusieurs des étapes suivantes du procédé. Après avoir formé les caissons d'oxyde complètement délimités, d'une part par les bordures 212 et d'autre part par la mince couche 222 de nitrure de silicium, on forme alors les connexions métalliques 240 de chacun des pixels. Ces connexions permettront, en fin de procédé, de connecter électriquement l'électrode conductrice transparente qui remplacera, dans chaque caisson 216, l'oxyde de silicium qui y est actuellement présent. Le matériau des connexions métalliques 240 est de préférence du tungstène (W) qui a une bonne conductivité électrique tout en étant résistant aux traitements thermiques qui vont suivre. Dans chaque pixel, la connexion métallique 240 peut aussi jouer un autre rôle très important. Elle va servir d'écran optique aux transistors de sélection qui vont être réalisés lors des étapes suivantes du procédé. Il ne faut pas en effet que la source de lumière qui illumine la matrice de pixels puisse affecter leur comportement électrique. Il faut donc avantageusement qu'un écran opaque recouvre toute sa surface comme schématisé sur la vue de dessus d'un pixel 202 en figure 6b. On comprend ici l'intérêt qu'il y a à réaliser des transistors de petite taille, cependant performants, pour affecter le moins possible le taux d'ouverture (OAR) du pixel.

Les connexions et écrans métalliques 240 en tungstène sont formés par le dépôt préalable d'une couche d'oxyde 230 dont l'épaisseur est typiquement de 350 nm. C'est dans cette couche que sont gravés d'une façon conventionnelle les motifs 240. Un dépôt uniforme de tungstène d'une épaisseur suffisante pour combler les motifs gravés est ensuite effectué. Ce dépôt est suivi d'une opération mécano chimique de polissage (CMP) dont le but est d'éliminer le tungstène au dessus des parties non gravées de la couche d'oxyde et d'aplanir la surface afin d'obtenir des îlots de tungstène 240, formant écrans et connexions aux pixels, incrustés dans l'oxyde 230 qui sert d'isolant.

Après aplanissement, une couche 250 avantageusement de nitrure de silicium ou de silicium polycristallin est avantageusement déposée puis gravée d'une façon conventionnelle par photolithographie pour y ouvrir les pixels en dehors des écrans en tungstène. L'épaisseur de cette couche est typiquement de 50 nm. Cette couche va faciliter l'ouverture des plots de contact avec les îlots de tungstène 240, comme décrit ultérieurement.

La **figure 2d** illustre le résultat des étapes suivantes du procédé dans lesquelles on va obtenir une mince couche de silicium monocristallin 270 sur une couche d'oxyde 260 pour réaliser une autre partie du dispositif. La couche monocristalline 270 va permettre d'y réaliser préférentiellement tous les transistors de sélection des pixels et, possiblement, toute l'électronique périphérique du dispositif avec d'excellentes performances.

La couche 260, d'une épaisseur typique de 400nm, est obtenue d'une façon conventionnelle par dépôt, sur toute la surface d'une tranche, d'un oxyde. Typiquement l'oxyde utilisé dans toutes ces opérations est l'oxyde de silicium (SiO2). La couche 260 est rendue plane à l'aide d'un nouveau polissage mécano chimique (CMP).

Pour obtenir la couche 270 de silicium monocristallin, il faut la transférer d'un substrat auxiliaire donneur 30. Toutes les techniques employées par l'industrie de la micro électronique pour fabriquer les substrats de type SOI mentionnés précédemment sont susceptibles d'être utilisées pour obtenir ce résultat. D'une façon classique un plan de fracture 32 illustré en figure 6c, pourra avoir été créé, par exemple, par implantation d'hydrogène dans le substrat donneur 30. Après retournement 34 et collage du substrat donneur sur la couche d'oxyde 260, un traitement thermique est avantageusement pratiqué qui permet de renforcer l'énergie de collage en cas de collage direct et éventuellement de réarranger la structure du silicium monocristallin qui pourrait avoir été perturbée par l'implantation ionique. Il sert surtout à fragiliser le plan de fracture 32 permettant une séparation du substrat donneur 30 par clivage, du seul fait du traitement thermique ou par l'application de forces mécaniques additionnelles. On obtient alors une couche 270 qui est polie (CMP) pour retrouver un état de surface satisfaisant et qui est solidaire de la couche d'oxyde 260. Le substrat donneur est réutilisable. On laisse en place une couche 270 dont l'épaisseur fait, typiquement, entre 100 et 300nm, par exemple 180 nm. On notera, qu'à ce stade du mode de réalisation illustré, le transfert 36 de couche ne pose pas le problème de la déformation de nappe adressé par l'invention puisque aucun motif n'avait été défini préalablement dans la couche transférée 270.

Le transfert de la couche 270 est suivi d'une ouverture dans cette couche de silicium des zones 272 afin que les marques de positionnement mentionnées ci-dessus restent visibles.

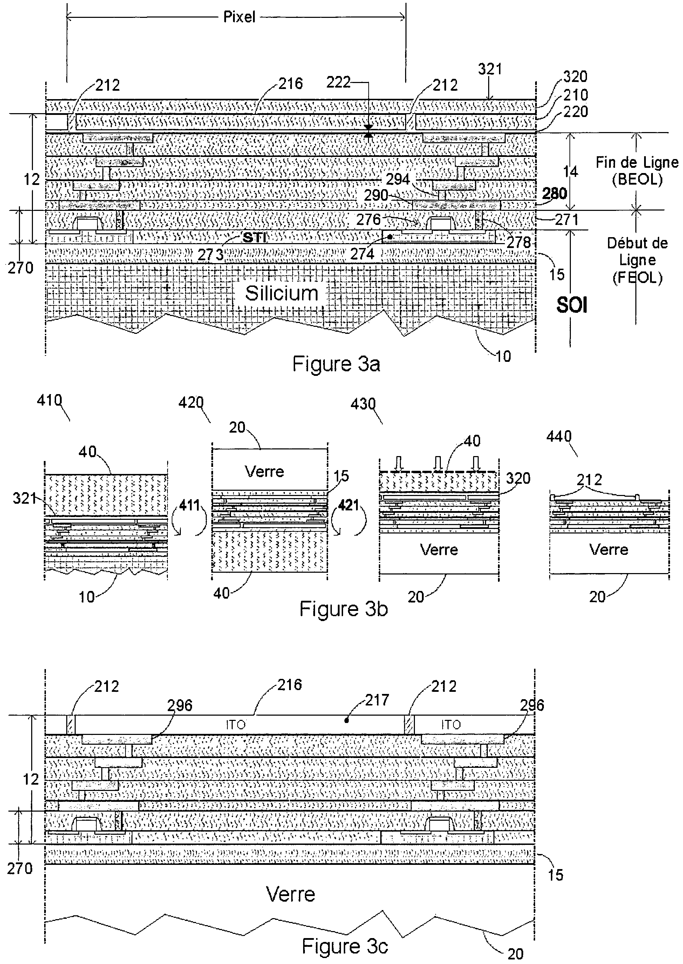

Par ailleurs, c'est à ce stade qu'on réalise dans, et à partir de la couche de silicium monocristallin 270, certains ou tous les composants actifs du dispositif, essentiellement des transistors. Ils sont encore dénommés de manière générale, composants électroniques additionnels. Par souci de clarté, ceux-ci ne sont pas représentés sur la figure 2d et les suivantes mais font partie intégrante de la couche 270. Les opérations de fabrication qui sont pratiquées à ce stade sont celles dites de FEOL, de l'anglais « front end of line », c'est-à-dire de « début de ligne » de fabrication : elles peuvent requérir des températures élevées qui doivent rester cependant compatibles avec le tungstène 240 qui a été utilisé pour la connexion aux pixels et pour créer l'écran des transistors de sélection. Typiquement, on va trouver dans cette couche 270 les sources et drains de transistors de type MOSFET, les plus utilisés par l'industrie de la microélectronique. De l'anglais « métal oxide semiconductor field effect transistor » c'est-à-dire « transistor à effet de champs métal-oxyde-semiconducteur », ces transistors comprennent une grille de commande généralement faite de silicium polycristallin conducteur. Le tout est noyé dans de l'oxyde. La couche 270 est donc une couche globale à base de silicium monocristallin. Sa structure ne sera en général pas différente de ce qui se pratique couramment pour la fabrication des circuits intégrés. Par exemple, une technologie très largement employée est celle dite CMOS, implémentant des transistors complémentaires (C) de type métal-oxyde-semiconducteur (MOS), à canal p et à canal n. Ils sont faits d'une façon standard à partir d'une couche de silicium monocristallin similaire à la couche 270 et peuvent donc y être réalisés si nécessaire. Pour une vue plus détaillée de la couche 270 on pourra se reporter à la figure 3a qui illustre une seconde mise en oeuvre du procédé de l'invention.

La **figure 2e** concerne les étapes ultérieures dite de BEOL de l'anglais « back end of line » c'est-à-dire de « fin de ligne » de fabrication où il s'agit de réaliser les interconnexions métalliques entre les composants actifs qui viennent d'être fabriqués dans, et à partir de la couche 270, comme expliqué ci-dessus. La formation des interconnexions en métal doit généralement être réalisée à des températures nettement plus basses que celles de « début de ligne ». Le métal utilisé est le plus souvent du cuivre actuellement. La mise en oeuvre du cuivre peut demander qu'une couche de tantale (Ta) et de nitrure de tantale (TaN) soit aussi utilisée pour empêcher sa diffusion dans les autres matériaux et en particulier dans le silicium. Cette technologie est devenue un standard de l'industrie de la microélectronique. Par souci de clarté ces couches ne sont pas ici représentées.

Les interconnexions en cuivre sont avantageusement réalisées par incrustation, ou damasquinage, de motifs en cuivre 290 dans une couche d'oxyde 280, préalablement déposée sur la couche 270 des composants actifs, et dans laquelle les motifs 290 ont été gravés. Les opérations sont globalement les mêmes que celles décrites pour obtenir l'écran en tungstène 240 incrusté dans la couche d'oxyde 230.

À ce stade, il faut cependant aussi réaliser les connexions verticales, c'est-à-dire les vias, qui permettent notamment d'atteindre les électrodes des composants actifs. Par souci de clarté, un seul niveau d'interconnexion est représenté sur la figure 2e et les suivantes. Il est constitué par la couche d'oxyde 280 dans laquelle les motifs en cuivre 290, qui servent à interconnecter les composants, sont incrustés. En pratique, il y a cependant généralement plus d'un niveau d'interconnexion. En fonction de la densité de câblage qu'il faut pouvoir réaliser, de 4 à 8 niveaux, séparés par des couches d'oxyde, sont couramment nécessaires. A titre d'exemple, on pourra se reporter à la figure 3a qui illustre une seconde mise en oeuvre de l'invention et où quatre niveaux d'interconnexions horizontales et verticales sont représentés. Le niveau représenté dans la figure 2e et les suivantes, situé le plus près des composants actifs contenus dans la couche 270, constitue le premier niveau d'interconnexion constitué des motifs en cuivre 290 incrustés dans la couche d'oxyde 280. Des vias, non représentés, permettent les connexions verticales entre niveaux. Les seuls vias qui sont représentés sont ceux qui concernent spécifiquement l'invention. Ces vias 292 permettent d'interconnecter la première couche de câblage et les écrans 240 en tungstène qui serviront, comme on le verra dans les dernières étapes du procédé, à connecter électriquement les électrodes des pixels avec les transistors de sélection qui ont été réalisés dans la couche de silicium monocristallin 270. Pour ce faire, on grave les vias 292 à travers la couche de silicium monocristallin 270, de préférence au niveau des zones d'oxyde que contient cette couche (zones dites STI, dont on trouvera une définition dans la figure 3a) afin d'éviter d'avoir à les isoler, puis à travers la couche d'oxyde 260 et les motifs 250 en nitrure de silicium couvrant les écrans pour atteindre les écrans en tungstène 240 eux-mêmes. Cette gravure est une gravure dite « profonde » car l'épaisseur de matériau à graver est importante vis-à-vis de l'épaisseur de tungstène sur laquelle il faut s'arrêter. C'est la raison pour laquelle on a prévu sur les plots de tungstène des plots de nitrure de silicium. Les ouvertures des vias sont réalisées en se servant des plots de nitrure de silicium comme arrêt à la gravure. On poursuit ensuite la gravure des plots de nitrure de silicium résiduels par gravure sélective vis-à-vis du tungstène jusqu'à atteindre ce dernier.

Après gravure des vias et des motifs d'interconnexion dans la couche d'oxyde 280 un dépôt de cuivre sur toute la surface de la tranche est effectué pour les remplir. Comme expliqué précédemment avec la formation des écrans en tungstène, le cuivre en excès au dessus des parties non gravées est enlevé et la surface aplanie au cours d'une opération suivante de polissage mécano chimique (CMP) qui ne laisse en place que les motifs de cuivre 290 isolés dans la couche d'oxyde 280.

Comme mentionné ci-dessus il y a généralement plus d'une couche de câblage. Les opérations ci-dessus sont répétées autant de fois qu'il y a de couches de câblage. Les couches sont isolées entre elles par une couche d'oxyde intercalaire. Leur interconnexion est assurée par des vias inter couches. Des vias servent aussi à connecter les électrodes des transistors. La formation des couches de câblage et des vias ci-dessus constitue l'essentiel des opérations standard de fin de ligne ou BEOL comme déjà discuté.

Quand les interconnexions métalliques voulues ont toutes été formées une nouvelle couche 300 uniforme d'oxyde de silicium est déposée. Elle est typiquement d'une épaisseur comprise entre 2000 et 3000 nm. Cette couche est une couche d'assemblage qui va servir de surface de collage sur le second substrat pour le transfert de la couche fonctionnelle 12 comme expliqué dans les étapes suivantes.

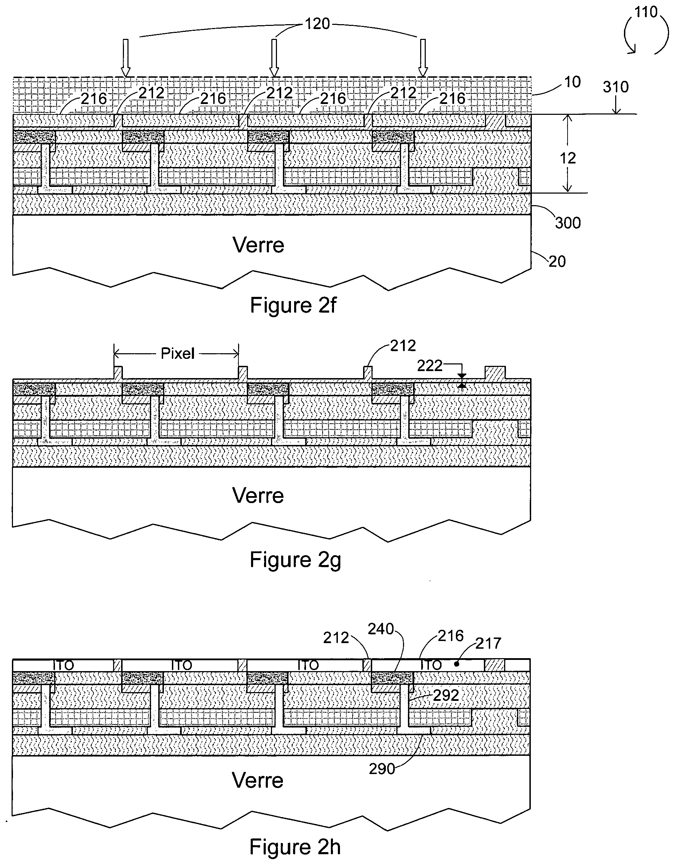

La **figure 2f** est une vue du dispositif en cours de fabrication après retournement 110 et transfert sur un second substrat 20 permettant de former une deuxième partie du dispositif. Dans le cas d'un dispositif optoélectronique, comme dans l'exemple de l'imageur utilisé pour décrire l'invention, ce second substrat est avantageusement transparent. Il s'agira typiquement d'un substrat en verre 20 dont la face supérieure est collée sur la couche d'oxyde 300 que l'on vient de décrire dans la figure précédente.

Le premier substrat 10 doit être alors enlevé jusqu'à atteindre la surface 310 des caissons 216 et bordures 212 qui ont été formées lors des premières étapes du procédé comme décrit en figure 1a. L'enlèvement du premier substrat 120 se fera, par exemple, par un amincissement avec attaques chimique et/ou mécanique. Un polissage final permet de retrouver un état de surface satisfaisant. L'arrêt du polissage se fait à détection des bordures 212 en nitrure de silicium qui est une céramique particulièrement dure.

La **figure 2g** montre le résultat de l'opération suivante qui consiste à enlever le matériau sacrificiel, l'oxyde de silicium formant les caissons 216. On notera que cette opération, et les suivantes décrites dans la figure 2h ci-après, ne nécessitent pas d'opération de photogravure. Elles s'accommodent donc sans problème de la déformation de nappe qui s'est possiblement produite lors du transfert de la couche fonctionnelle 12 comme décrit dans la figure précédente. L'enlèvement du matériau sacrificiel, l'oxyde de silicium emplissant les caissons 216, se fait à l'aide d'une attaque chimique sélective, sur toute la surface d'une tranche, par exemple par gravure RIE, qui laisse en place les bordures 212 et la mince couche 222 de nitrure de silicium présente au fond des caissons.

Comme montré sur la **figure 2h****,** il faut ensuite enlever la mince couche 222 de nitrure de silicium présente au fond des caissons de façon à assurer un contact électrique entre l'écran 240 et le matériau 217 qui va finalement remplir les caissons 216. Ce matériau est typiquement de l'ITO, acronyme de l'anglais « Indium tin oxide » qui désigne un « oxyde d'étain et d'indium » matériau transparent et conducteur très souvent utilisé comme électrode dans les dispositifs optoélectroniques.

L'enlèvement de la couche 222 se fait de préférence à l'aide d'une attaque, de préférence anisotrope, limitée en temps, du nitrure de silicium (ou d'un autre matériau éventuellement) de façon à laisser en place l'essentiel des bordures 212 qui auto délimitent les pixels. Si, comme mode optionnel de réalisation mentionné précédemment, le fond des caissons 222 a été délimité par un autre matériau que le nitrure de silicium, une gravure sélective vis-à-vis du nitrure de silicium ici donné comme exemple pour la délimitation latérale, du tungstène et de l'oxyde sous-jacent est pratiquée. L'ITO est ensuite déposé sur toute la surface de la tranche puis aplani par un polissage mécano chimique (CMP) qui ne laisse en place, comme montré, que les caissons 216 remplis d'ITO 217 servant d'électrode conductrice des pixels. C'est au dessus des électrodes en ITO que les composants optiques (non représentés) seront formés. Notamment en insérant une couche de cristaux liquides dont la polarisation sera commandée au droit de chaque pixel par l'électrode en ITO. Elle est elle-même commandée par les transistors de sélection et l'électronique périphérique (non représentés) contenus dans la couche 270 par l'intermédiaire des vias 292 et connexions métalliques 290 précédemment discutées.

Le procédé décrit dans les figures 2a à 2h s'affranchit donc complètement des déformations de nappe en n'ayant pas recours à des opérations de photolithographie ou de positionnement pour réaliser les pixels après transfert de la couche électronique fonctionnelle. Les pixels sont auto alignés sur la partie électronique transférée. L'écran 240 recouvre complètement le transistor de sélection et son positionnement n'est pas affecté par la déformation de nappe.

Les **figures 3a à 3c** illustrent une deuxième mise en oeuvre du procédé selon l'invention au cours de laquelle on transfert d'abord la couche fonctionnelle sur un substrat auxiliaire.

La **figure 3a** est une vue en coupe du dispositif optoélectronique utilisé pour décrire le procédé de l'invention après que toutes les étapes de fabrication devant intervenir avant transfert de la couche fonctionnelle 12 ont été exécutées.

Dans cette seconde mise en oeuvre de l'invention, toute la partie électronique du dispositif est réalisée typiquement à partir d'un premier substrat 10 avantageusement de type SOI. Tous les composants actifs peuvent être alors réalisés comme pour n'importe quel circuit intégré standard. Dans des îlots 274 de silicium monocristallin électriquement isolés les uns des autres par de l'oxyde 273 formés selon une technique dite STI, de l'anglais « shallow trench isolation », c'est-à-dire « isolation par tranchées peu profondes » on réalise des transistors 276 de type MOSFET. Les grilles des transistors en silicium polycristallin et les vias 278 d'accès aux électrodes du transistor depuis le premier niveau d'interconnexions, sont noyés dans une couche aplanie d'oxyde 271. Comme on l'a vu précédemment, les opérations de réalisation de ces transistors sont dites de début de ligne (FEOL).

Les opérations de fabrication qui suivent, dites de fin de fin de ligne (BEOL), destinées à réaliser toutes les interconnexions entre composants, nécessitent plusieurs niveaux de câblage qui sont réalisés chacun, comme déjà expliqué, par incrustation de cuivre dans une couche d'oxyde. À titre d'exemple, quatre niveaux de câblage sont représentés qui incluent, et sont similaires dans leur structure, au premier niveau constitué des motifs en cuivre 290 incrustés dans la couche d'oxyde 280. Ensemble ils constituent la couche globale 14 de câblage servant à interconnecter tous les composants du dispositif. Les connexions entre niveaux se font préférentiellement à l'aide de vias verticaux tel que 294.

Jusqu'à ce stade les opérations de fabrication de la partie réalisée avant transfert peuvent être identiques à celles nécessaires à la réalisation d'un circuit intégré électronique conventionnel. Les opérations qui suivent sont spécifiques à l'invention. Elles consistent à former les caissons d'oxyde 216 de la couche sacrificielle 210, déjà décrits dans la figure 2a. La méthode d'obtention de ces caissons complètement enrobés dans une couche 220 par exemple de nitrure de silicium est toutefois différente. Une mince couche 222 de nitrure de silicium, d'une épaisseur typique de 40 nm, est cette fois d'abord déposée sur toute la surface de la tranche pour isoler le fond des caissons 216. La couche 210 d'oxyde de silicium dans laquelle on va graver par photolithographie les ouvertures correspondant en négatif aux bordures 212 des pixels est ensuite déposée. Les ouvertures sont alors remplies par un second dépôt de matériau de délimitation tel que le nitrure de silicium. Le nitrure en excès sur les parties d'oxyde non gravées, en dehors des ouvertures, est enlevé, et la surface aplanie, à l'aide d'une opération de polissage mécano chimique (CMP). Ces opérations sont suivies par le dépôt d'une couche supplémentaire d'oxyde de silicium 320 et d'un nouveau polissage mécano chimique de la surface 321 afin d'obtenir un état de surface permettant un collage en vue d'un premier transfert sur un support temporaire qui va jouer le rôle de « poignée » de manipulation de la couche fonctionnelle.

La **figure 3b** schématise les deux opérations de transfert de la couche fonctionnelle qui vont permettre que celle-ci soit finalement associée à un substrat transparent, par exemple un substrat de verre.

Comme montré en 410, la poignée de manipulation, c'est-à-dire un substrat intermédiaire avantageusement de silicium 40, est collé, avantageusement par collage démontable, présentant par exemple une faible énergie de collage, sur la face supérieure 321 de la couche d'assemblage 320 de la structure correspondant à la figure 3a contenant la couche fonctionnelle déjà fabriquée.

Après retournement 411 et enlèvement du silicium du substrat initial 10 de type SOI jusqu'à la couche enterrée 15 on peut procéder, comme montré sur la portion de figure 420, au collage du substrat de verre 20 sur la couche enterrée 15, maintenant apparente, du substrat SOI initial 10. L'enlèvement du silicium du substrat SOI illustré en 430 peut se faire en combinant attaques mécaniques et chimiques jusqu'à détection de la couche d'oxyde enterrée. L'attaque chimique utilise par exemple un produit de gravure du silicium connu sous l'appellation de TMAH ou « hydroxyde d'ammonium tétraméthylique ». Un polissage de type CMP est pratiqué sur la couche enterrée 15 pour obtenir un état de surface qui va permettre le collage du substrat de verre 20.

Après un nouveau retournement 421 c'est le substrat auxiliaire 40 en silicium, la poignée de manipulation, qui est enlevé jusqu'à retrouver la couche d'oxyde 320 protégeant la couche fonctionnelle 12. Cet enlèvement peut se faire dans les mêmes conditions que ci-dessous. Dans ce cas, le substrat poignée est détruit. Optionnellement, si un collage démontable a été utilisé, il est possible de démonter la poignée au niveau de l'interface de collage, par exemple par l'application de forces mécaniques. Dans ce cas, la poignée est préservée et peut être réutilisée, après un éventuel reconditionnement, pour un nouveau transfert.

Comme montré en 440, la couche d'oxyde 320 est à son tour enlevée et l'oxyde sacrificiel des caissons 216 gravé, dans les mêmes conditions que décrit précédemment dans la figure 2g, ce qui ne laisse en place que les bordures 212 et la couche 222 de nitrure de silicium au fond des caissons.

Le résultat final est montré sur la **figure3c****.** Comme décrit précédemment dans la figure 2h, on grave le nitrure de silicium pour ne laisser que les bordures qui ont typiquement une largeur finale de 0,5 micron. Les caissons sont remplis d'ITO 217 comme décrit également dans la figure 2h définissant sans photolithographie les pixels du dispositif.

Dans cette seconde mise en oeuvre du procédé de l'invention on remarquera que les électrodes en ITO sont alors en contact électrique direct avec les motifs en cuivre 296 de la couche supérieure de câblage et qu'il n'a pas été nécessaire de former des motifs de contact en tungstène 240 et des vias 292 pour y accéder.

Avantageusement, les motifs en tungstène 240, qui servent aussi d'écran optique aux transistors de sélection 276, sont remplacés par l'un ou l'autre des motifs en cuivre de la couche globale de câblage 14. Les motifs en cuivre de la couche globale 14 peuvent aussi avantageusement être combinés géométriquement pour ensemble former l'écran optique protégeant les transistors de sélection 276.

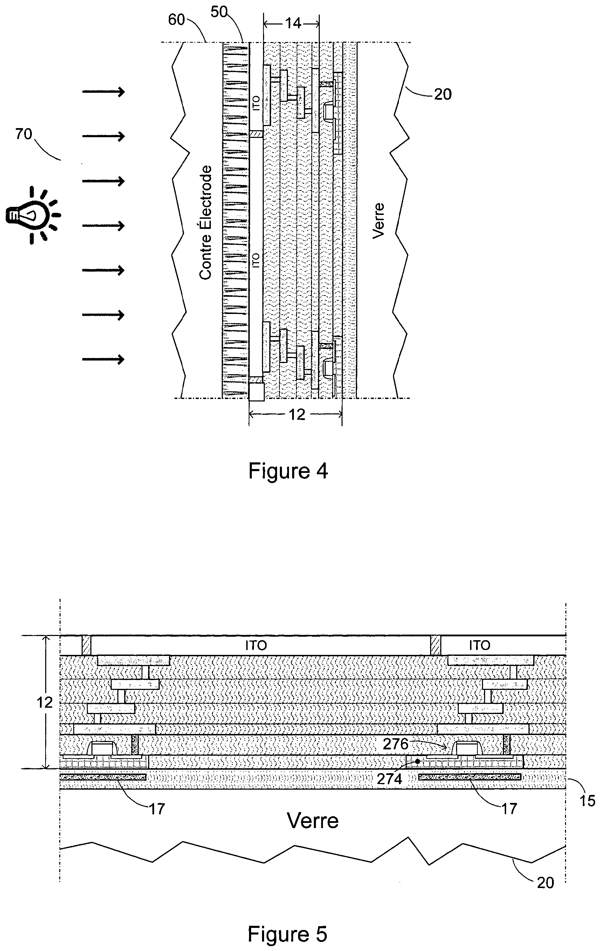

La **figure 4** illustre les parties optiques principales d'un dispositif optoélectronique selon l'invention réalisées à l'issue des étapes du procédé décrites ci-dessus. Dans ce type de dispositif, on forme notamment une couche de cristaux liquides 50 qui est insérée entre une contre électrode transparente 60 et les électrodes en ITO 217 de la couche fonctionnelle 12 fabriquée selon le procédé décrit dans les figures 2a à 2h ou celui des figures 3a à 3c. Des filtres colorés (non représentés) peuvent être également prévus sur la contre électrodes.

Avantageusement, un imageur fabriqué selon le procédé de l'invention peut être éclairé du côté de la contre électrode 60 perpendiculairement à celle-ci. Les rayons lumineux 70, qui peuvent être générés par une source cohérente comme un laser, forment alors un faisceau parfaitement collimaté qui traverse la contre électrode et la couche de cristaux liquides avec une incidence normale. En l'absence de filtres colorés (par exemple, dans le cas d'un écran monochrome ou dans le cas d'un écran couleur dont chaque couleur est traitée séquentiellement), la contre électrode et la couche de cristaux liquides ne contenant aucun motif, aucune diffraction des rayons ne se produit. L'incidence normale de l'éclairage de la couche 50 permet d'optimiser les performances des cristaux liquides contenus dans cette couche. On peut alors obtenir des temps de réponses extrêmement courts, des contrastes élevés avec des tensions de commandes très faibles. Pour maintenir ces résultats, en particulier pour ne pas voir le contraste diminuer sensiblement, il ne faut pas que les rayons lumineux incidents puissent être déviés de leur trajectoire. Ce qui serait le cas si l'éclairage de l'imageur devait se faire par l'autre côté, c'est-à-dire à travers le substrat transparent en verre 20. Les rayons lumineux seraient alors susceptibles d'être diffractés, notamment par les différents motifs métalliques de la couche globale de câblage 14, avant même de traverser la couche de cristaux liquides 50 perdant ainsi l'avantage qu'il y aurait à utiliser une source de lumière cohérente et dégradant très sensiblement les performances du dispositif optoélectronique.

La **figure 5** illustre une étape optionnelle préliminaire à la deuxième mise en oeuvre du procédé selon l'invention décrit dans les figures 3a à 3c. On a vu que dans ce cas les écrans qui protègent les transistors de sélection de la source de lumière incidente servant à éclairer les pixels sont constitués par les motifs métalliques de la couche globale de câblage 14.

Toutefois, il se peut que dans cette structure un peu de lumière soit réfléchie par le substrat en verre 20, ou provienne de la lumière ambiante traversant ce substrat transparent. Quoique les transistors de sélection 276 soient partiellement protégés de ce côté par le silicium 274 dans lequel ils sont formés, mais afin que le fonctionnement des transistors de sélection et l'électronique périphérique ne puissent en aucun cas être affectés, l'invention prévoit qu'une étape préliminaire puisse être effectuée au cours de laquelle on va créer aussi un écran 17 avantageusement en tungstène sous chacun des transistors de sélection. Pour obtenir ce résultat on peut alors appliquer les étapes du procédé concernant la formation de l'écran en tungstène décrit dans la figure 2b. Le résultat est comme montré dans la figure 5. L'écran en tungstène est noyé dans la couche d'oxyde 15 qui correspond à celle dite BOX ou « oxyde enterré » d'un substrat standard SOI. Pour mettre en oeuvre l'étape supplémentaire décrite dans la figure 5, il faudra que cette couche 15 soit réalisée en plusieurs étapes comme décrit dans la figure 2b et on ne pourra pas dans ce cas partir d'un substrat standard SOI. On notera que l'écran 17 ne joue que le rôle d'écran optique et n'a pas besoin d'être électriquement relié à autre chose. Il n'y a donc pas besoin de via pour le connecter dans ce cas.

On remarquera finalement que quels que soient les modes de réalisation décrits dans les figures précédentes, l'alignement du ou des écrans protégeant les transistors de sélection est toujours nominal et ne dépend pas de la déformation de nappe puisque toutes les opérations de photolithographie sont effectuées avant transfert. Le taux d'ouverture des pixels (OAR) reste optimal, il est typiquement supérieur à 70%. Les pixels définis par leur électrode dans un matériau transparent électriquement conducteur l'ITO sont auto alignés quelle que soit l'importance de la déformation de nappe constatée ce qui peut permettre de relaxer les contraintes et spécifications de l'étape de collage sur le substrat en verre lors du transfert de la couche fonctionnelle. Enfin, comme on l'a vu dans la figure 4 l'éclairage peut se faire du côté de la contre électrode ce qui évite toute diffraction avant de traverser la couche de cristaux liquides.

## Revendications

1. Procédé de fabrication d'un dispositif opto-microélectronique à partir d'un premier substrat (10) semi-conducteur comprenant la réalisation d'au moins une électrode d'un pixel après un transfert d'une couche fonctionnelle (12) du premier substrat (10) sur un deuxième substrat (20), **caractérisé en ce qu'**il comporte :
une première phase effectuée avant le transfert et comprenant :
i) la formation dans une couche formée en surface du premier substrat (10) d'au moins un motif d'électrode fait d'un matériau sacrificiel,
ii) la délimitation latérale du motif dans la couche du premier substrat (10) par une bordure (212) en un matériau de délimitation différant du matériau sacrificiel,
une deuxième phase effectuée après transfert et comprenant le remplacement du motif par l'électrode incluant un enlèvement du matériau sacrificiel du motif par une gravure sélective configurée de sorte à attaquer le matériau sacrificiel et à préserver le matériau de délimitation sans recours à une photolithographie, ledit remplacement résultant en un raccordement électrique de l'électrode à un transistor de sélection de la couche fonctionnelle (12).

2. Procédé selon la revendication précédente dans lequel on choisit du nitrure de silicium ou du silicium polycristallin comme matériau de délimitation.

3. Procédé selon l'une des revendications précédentes dans lequel le motif est un caisson (216) entouré latéralement intégralement par la bordure (212).

4. Procédé selon la revendication précédente dans lequel la bordure (212) est obtenue, par dépôt autour du motif, du matériau de délimitation et dans lequel on forme une couche (222) de matériau de délimitation au dessus de la couche comprenant le motif.

5. Procédé selon la revendication précédente dans lequel la bordure (212) est en un matériau de délimitation différent du matériau de délimitation de la couche (222).

6. Procédé selon l'une des deux revendications précédentes comprenant, après dépôt autour du motif, amincissement de la couche (222) de matériau de délimitation jusqu'à obtenir une épaisseur inférieure à la dimension latérale minimale et à l'épaisseur de la bordure (212).

7. Procédé selon l'une des trois revendications précédentes dans lequel la première phase comprend la formation d'un écran (240) à la lumière en superposition au motif.

8. Procédé selon la revendication précédente dans lequel l'écran (240) est formé par photolithographie dans une couche formée sur le premier substrat (10) en superposition à la couche incluant le motif.

9. Procédé selon l'une des deux revendications précédentes dans lequel l'écran (240) est formé en matériau électriquement conducteur.

10. Procédé selon la revendication précédente dans lequel le matériau électriquement conducteur est du tungstène.

11. Procédé selon l'une des revendications 5 ou 6 dans lequel la deuxième phase comprend, après l'enlèvement du matériau sacrificiel du motif, l'enlèvement de la couche (222) de matériau de délimitation.

12. Procédé selon la revendication précédente dans lequel l'enlèvement de la couche (222) de matériau de délimitation est effectué par gravure de temps contrôlé de sorte enlever la couche (222) de matériau de délimitation et à préserver la bordure (212).

13. Procédé selon l'une des revendications précédentes dans lequel le remplacement du motif par l'électrode comprend, après l'enlèvement du matériau sacrificiel du motif, un dépôt du matériau de l'électrode.

14. Procédé selon la revendication précédente comprenant un amincissement de l'épaisseur du dépôt du matériau du composant électronique jusqu'au niveau de l'épaisseur de la bordure (212).

15. Procédé selon l'une des revendications précédentes comprenant, avant le transfert, la formation de la couche incluant le motif sur le premier substrat (10), suivie de la formation d'au moins une couche incluant au moins un composant électronique additionnel puis de la formation d'une couche d'assemblage (300).

16. Procédé selon la revendication 15 dans lequel le transfert comprend un report du premier substrat (10) sur le deuxième substrat effectué par la couche d'assemblage (300) du premier substrat (10) et dans lequel on réduit l'épaisseur du premier substrat (10) jusqu'à la couche incluant le motif.

17. Procédé selon l'une des revendications 1 à 14 comprenant, avant le transfert, la formation d'au moins une couche incluant au moins un composant électronique additionnel sur le premier substrat (10), suivie de la formation de la couche incluant le motif puis de la formation d'une couche d'assemblage (320), dans lequel le transfert comprend :
un report du premier substrat (10) par une face externe de la couche d'assemblage sur un substrat intermédiaire (40),
une réduction de l'épaisseur du premier substrat (10) jusqu'au niveau d'une face interne,
un transfert de la au moins une couche incluant au moins un composant électronique additionnel, de la couche incluant le motif et de la couche d'assemblage (320) par la face interne sur le deuxième substrat,
une élimination du substrat intermédiaire (40) et une réduction de l'épaisseur de la couche d'assemblage (320) jusqu'à la couche incluant le motif.

18. Procédé selon la revendication 9 ou 10 seule ou en combinaison avec l'une des revendications 11 à 16 comprenant :
- une étape de formation d'un motif (250) couvrant l'écran (240) ;
- une étape de dépôt d'une couche d'oxyde (260) de silicium ;
- une étape d'aplanissement de la couche d'oxyde (260) par polissage;
- une étape de formation d'une couche (270) de silicium monocristallin sur la couche d'oxyde (260) par transfert depuis un substrat donneur (30).

19. Procédé selon la revendication précédente comprenant la réalisation, dans la couche (270) de silicium monocristallin, du transistor de sélection et la réalisation d'un via (292) interconnectant électriquement le transistor de sélection et l'écran (240).

20. Procédé selon la revendication précédente dans lequel la réalisation du via (292) comprend :
- une gravure depuis la couche (270) de silicium monocristallin ;
- un arrêt de la gravure sur le motif (250) ;
- une gravure sélective du motif (250) configurée pour enlever le matériau du motif (250) sans enlever celui de l'écran (240).

21. Procédé selon l'une des revendications précédentes pour la fabrication d'un imageur de diagonale de moins de 2,54 centimètres à éclairage transmissif.

## Patentansprüche

1. Verfahren zur Herstellung einer optomikroelektronischen Vorrichtung aus einem ersten Halbleitersubstrat (10), umfassend die Herstellung mindestens einer Elektrode von einem Pixel nach einem Transfer einer funktionellen Schicht (12) von dem ersten Substrat (10) auf ein zweites Substrat (20), **dadurch gekennzeichnet, dass** es umfasst:
eine erste Phase, die vor dem Transfer ausgeführt wird und umfasst:
i) die Bildung mindestens eines Elektrodenmotivs, das aus einem Opfermaterial besteht, in einer an der Oberfläche des ersten Substrats (10) gebildeten Schicht,
ii) die seitliche Begrenzung des Motivs in der Schicht des ersten Substrats (10) durch eine Umrandung (212) aus einem Begrenzungsmaterial, das sich von dem Opfermaterial unterscheidet,
eine zweite Phase, die nach dem Transfer ausgeführt wird und den Ersatz des Motivs durch die Elektrode umfasst, einschließlich einer Abhebung des Opfermaterials des Motivs durch eine selektive Gravur, die dazu vorgesehen ist, das Opfermaterial anzugreifen und das Begrenzungsmaterial zu bewahren, ohne auf eine Photolithographie zurückzugreifen, wobei sich der Ersatz aus einem elektrischen Anschluss der Elektrode an einen Transistor zur Auswahl der funktionellen Schicht (12) ergibt.

2. Verfahren nach dem vorhergehenden Anspruch, bei dem Siliziumnitrid oder polykristallines Silizium als Begrenzungsmaterial gewählt wird.

3. Verfahren nach einem der vorhergehenden Ansprüche, bei dem das Motiv eine Kassette (216) ist, die seitlich zur Gänze von der Umrandung (212) umgeben ist.

4. Verfahren nach dem vorhergehenden Anspruch, bei dem die Umrandung (212) durch Aufbringen des Begrenzungsmaterials um das Motiv erhalten wird, und bei dem eine Schicht (222) aus Begrenzungsmaterial über der das Motiv umfassenden Schicht gebildet wird.

5. Verfahren nach dem vorhergehenden Anspruch, bei dem die Umrandung (212) aus einem anderen Begrenzungsmaterial als das Begrenzungsmaterial der Schicht (222) ist.

6. Verfahren nach einem der beiden vorhergehenden Ansprüche, umfassend nach dem Aufbringen um das Motiv eine Ausdünnung der Schicht (222) aus Begrenzungsmaterial, bis eine geringere Dicke als die minimale seitliche Dimension und als die Dicke der Umrandung (212) erhalten wird.

7. Verfahren nach einem der drei vorhergehenden Ansprüche, bei dem die erste Phase die Bildung eines Lichtabschirmelements (240) in Überlagerung über das Motiv umfasst.

8. Verfahren nach dem vorhergehenden Anspruch, bei dem der Bildschirm (240) durch Photolithographie in einer Schicht ausgebildet ist, die auf dem ersten Substrat (10) in Überlagerung über die das Motiv einschließende Schicht ausgebildet ist.

9. Verfahren nach einem der beiden vorhergehenden Ansprüche, bei dem die Abschirmung (240) aus einem elektrisch leitenden Material gebildet ist.

10. Verfahren nach dem vorhergehenden Anspruch, bei dem das elektrisch leitende Material Wolfram ist.

11. Verfahren nach einem der Ansprüche 5 oder 6, bei dem die zweite Phase nach der Abhebung des Opfermaterials des Motivs die Abhebung der Schicht (222) von Begrenzungsmaterial umfasst.

12. Verfahren nach dem vorhergehenden Anspruch, bei dem die Abhebung der Schicht (222) von Begrenzungsmaterial durch Gravur mit kontrollierter Zeit erfolgt, um die Schicht (22) von Begrenzungsmaterial abzuheben und die Umrandung (212) zu bewahren.

13. Verfahren nach einem der vorhergehenden Ansprüche, bei dem der Ersatz des Motivs durch die Elektrode nach der Abhebung des Opfermaterials des Motivs ein Aufbringen des Materials der Elektrode umfasst.

14. Verfahren nach dem vorhergehenden Anspruch, umfassend eine Ausdünnung der Dicke des aufgebrachten Materials der elektronischen Komponente bis zum Niveau der Dicke der Umrandung (212).

15. Verfahren nach einem der vorhergehenden Ansprüche, umfassend vor dem Transfer die Bildung der das Motiv einschließenden Schicht auf dem ersten Substrat (10), gefolgt von der Bildung mindestens einer Schicht, die mindestens eine zusätzliche elektronische Komponente einschließt, dann der Bildung einer Verbindungsschicht (300).

16. Verfahren nach Anspruch 15, bei dem der Transfer eine Verschiebung des ersten Substrats (10) auf das zweite Substrat umfasst, die durch die Verbindungsschicht (300) des ersten Substrats (10) durchgeführt wird, und bei der die Dicke des ersten Substrats (10) bis zu der das Motiv einschließenden Schicht verringert wird.

17. Verfahren nach einem der Ansprüche 1 bis 14, umfassend vor dem Transfer die Bildung mindestens einer Schicht, die mindestens eine zusätzliche elektronische Komponente einschließt, auf dem ersten Substrat (10), gefolgt von der Bildung der das Motiv einschließenden Schicht, dann der Bildung einer Verbindungsschicht (320), wobei der Transfer umfasst:
- eine Verschiebung des ersten Substrats (10) durch eine Außenseite der Verbindungsschicht auf ein Zwischensubstrat (40),
- eine Verringerung der Dicke des ersten Substrats (10) bis auf das Niveau einer Innenseite,
- eine Verschiebung der mindestens einen Schicht, die mindestens eine zusätzliche elektronische Komponente einschließt, der das Motiv einschließenden Schicht und der Verbindungsschicht (320) durch die Innenseite auf das zweite Substrat,
- eine Beseitigung des Zwischensubstrats (40) und eine Verringerung der Dicke der Verbindungsschicht (320) bis zu der das Motiv einschließenden Schicht.

18. Verfahren nach Anspruch 9 oder 10 alleine oder in Kombination mit einem der Ansprüche 11 bis 16, umfassend:
- einen Schritt der Bildung eines Motivs (250), das die Abschirmung (240) abdeckt;
- einen Schritt der Aufbringung einer Siliziumoxidschicht (260);
- einen Schritt des Planierens der Oxidschicht (260) durch Polieren;
- einen Schritt der Bildung einer monokristallinen Siliziumschicht (270) auf der Oxidschicht (260) durch Transfer von einem Donorsubstrat (30).

19. Verfahren nach dem vorhergehenden Anspruch, umfassend die Herstellung des Auswahltransistors in der monokristallinen Siliziumschicht (270) und die Herstellung eines Kanals (292), der den Auswahltransistor und die Abschirmung (240) elektrisch zusammenschließt.

20. Verfahren nach dem vorhergehenden Anspruch, bei dem die Herstellung des Kanals (292) umfasst:
- eine Gravur von der monokristallinen Siliziumschicht (270) aus;
- ein Anhalten der Gravur auf dem Motiv (250);
- eine selektive Gravur des Motivs (250), die dazu vorgesehen ist, das Material des Motivs (250) abzuheben, ohne jenes der Abschirmung (240) abzuheben.

21. Verfahren nach einem der vorhergehenden Ansprüche zur Herstellung eines Bildgebungselements mit einer Diagonale von weniger als 2,54 Zentimeter transmissiver Beleuchtung.

## Claims

1. A method for manufacturing an opto-microelectronic device from a first semiconductor substrate (10), comprising the production of at least one electrode of a pixel after a transfer of the functional layer (12) of the first substrate (10) onto a second substrate (20), **characterized in that** it comprises:
- a first phase carried out before the transfer and comprising:
i) forming at least one pattern made of a sacrificial material in a layer formed in the first substrate (10) surface,
ii) a lateral delimitation of the pattern in the layer of the first substrate (10) by an edge (212) of a boundary material differing from the sacrificial material,
- a second phase carried out after the transfer and comprising a substitution of the electrode for the pattern including a removal of the sacrificial material of the pattern by a selective etching so configured as to attack the sacrificial material and to preserve the boundary material without using photolithography, said substitution resulting in an electrical connection of the electrode to a selection transistor of the functional layer (12).

2. A method according to the preceding claim wherein silicon nitride or polycrystalline silicon is selected as the boundary material.

3. A method according to one of the preceding claims, wherein the pattern is a box (216) entirely surrounded laterally by the edge (212).

4. A method according to the preceding claim, wherein the edge (212) is obtained by deposition around the pattern of the boundary material and wherein a layer (222) of the boundary material is formed above the layer comprising the pattern.

5. A method according to the preceding claim, wherein the edge (212) is of a boundary material different from the boundary material of the layer (222).

6. A method according to one of the two preceding claims comprising, after the deposition around the pattern, the thinning of the layer (222) of the boundary material until a thickness lower than the minimum lateral dimension and the thickness of the edge (212) is obtained.

7. A method according to one of the three preceding claims, wherein the first phase comprises forming a light screen (240) superimposed on the pattern.

8. A method according to the preceding claim, wherein the screen (240) is formed by photolithography in a layer formed on the first substrate (10) and is superimposed on the layer including the pattern.

9. A method according to one of the two preceding claims, wherein the screen (240) is formed in an electrically conductive material.

10. A method according to the preceding claim, wherein the electrically conductive material is tungsten.

11. A method according to one of claims 5 or 6, wherein the second phase comprises, after removal of the sacrificial material of the pattern, removing the layer (222) of boundary material.

12. A method according to the preceding claim, wherein the removal of the layer (222) of the boundary material is carried out by etching controlled in time so as to remove the layer (222) of the boundary material and to preserve the edge (212).

13. A method according to one of the preceding claims, wherein the substitution of the electrode for the pattern includes, after removal of the sacrificial material of the pattern, a deposition of the electrode material.

14. A method according to the preceding claim, comprising a thinning of the thickness of the deposition of the electronic component material to the level of the thickness of the edge (212).

15. A method according to one of the preceding claims, comprising, before the transfer, forming the layer including the pattern on the first substrate (10), followed by forming at least one layer including at least one additional electronic component then forming a connecting layer (300).

16. A method according to claim 15, wherein the transfer comprises transferring the first substrate (10) onto the second substrate carried out by the connecting layer (300) of the first substrate (10) and wherein the thickness of the first substrate (10) is reduced until the layer including the pattern is reached.

17. A method according to one of claims 1 to 14, comprising, before the transfer, forming at least one layer including at least one additional electronic component on the first substrate (10), followed by forming the layer including the pattern and then forming a connecting layer (320), wherein the transfer comprises:
- transferring the first substrate (10) by an outer face of the connecting layer onto an intermediate substrate (40),
- reduction in the thickness of the first substrate (10) until an inner face is reached,
- transfer of the at least one layer including at least one additional electronic component, of the layer including the pattern and of the connecting layer (320) by the inner face onto the second substrate,
- removal of the intermediate substrate (40) and a reduction in the thickness of the connecting layer (320) until the layer including the pattern is reached.

18. A method according to claim 9 or 10, alone or in combination with one of claims 11 to 16, comprising:
- a step of forming a pattern (250) covering the screen (240);
- a step of depositing a layer (260) of silicon oxide;
- a step of flattening the layer (260) of silicon oxide by polishing;
- a step of forming a layer (270) of single-crystal silicon on the layer (260) of silicon oxide by transfer from a donor substrate (30).

19. A method according to the preceding claim, comprising the production, in the layer (270) of single-crystal silicon, of the selection transistor and the production of a via (292) electrically interconnecting the selection transistor and the screen (240).

20. A method according to the preceding claim, wherein the production of the via (292) comprises:
- etching from the layer (270) of single-crystal silicon;
- stopping the etching on the pattern (250);
- selective etching of the pattern (250) so configured as to remove the pattern material (250) without removing the screen material (240).

21. A method according to one of the preceding claims, for manufacturing an imaging device having a diagonal of less than 2.54cm with transmission lighting.
